# EUROPEAN PATENT APPLICATION

(11) **EP 4 572 550 A1**
(43) Date of publication of application: **18.06.2025**
(21) Application number: 23383297.1
(22) Date of filing: 14.12.2023
(51) Int. Cl.: H05K 7/20

(54) **CIRCUIT ARRANGEMENT AND METHOD FOR MANUFACTURING A CIRCUIT ARRANGEMENT**

(71) Applicant: E.G.O. Elektro-Gerätebau GmbH, 75038 Oberderdingen (DE)
(72) Inventor: Torres, Toni, 08185 Lliçà de Vall (ES); Reverte, Albert, 08185 Lliçà de Vall (ES); Cruz, Toni, 08185 Lliçà de Vall (ES); Travé Ramis, Anna, 08185 Lliçà de Vall (ES)
(74) Representative: Patentanwälte Ruff, Wilhelm, Beier, Dauster & Partner mbB

(57) **Abstract**

A circuit arrangement comprises a circuit carrier with contact pads and conductor tracks thereon, electronic components on the circuit carrier generating heat in their operation. A heat sink is provided for receiving heat from the circuit carrier and from the components, wherein the heat sink is made of aluminum and is fastened to the circuit carrier and bears directly against the circuit carrier. At least two electrical contacts, which are separate from one another and against which the heat sink rests in an electrically conductive manner, are arranged on the upper side of the circuit carrier against which the heat sink rests. The two electrical contacts are electrically connected to conductor tracks and to a control in order to measure electrical through-contacting by the heat sink by means of the two electrical contacts.

## Description

### Field of application and prior art

The invention is directed to a circuit arrangement comprising a circuit carrier with electronic components on it and a heat sink for cooling the circuit carrier or at least some of the electronic components, respectively. The invention is also directed to a method for manufacturing such a circuit arrangement.

Heat sinks made of aluminum for circuit arrangements or the like are for example known from DE 19712723 A1. It is also known in the art, for example from EP 4096361 A1, to arrange a heat sink made of aluminum on a circuit carrier, wherein electronic components such as IGBTs or the like are electrically connected on the circuit carrier. They are also partly attached to the heat sink for efficient cooling.

### Object and solution

It is an object of the invention at hand to provide a circuit arrangement as well as a method of manufacturing such a circuit arrangement with which problems in the art can be avoided and, in particular, a cooling effect of the heat sink for the circuit carrier or electronic components provided thereon can be enlarged, preferably with fast and efficient manufacturing of such a circuit arrangement.

This object is achieved by a circuit arrangement according to the invention having the features of claim 1 as well as a method of manufacturing such a circuit arrangement according to the invention having the features of claim 14. Preferred and advantageous embodiments of the invention are part of the further claims and will be described later. Some of the features are only described for the circuit arrangement or for a method of its manufacturing. However, independent of this, they shall be valid and be applied to such a circuit arrangement or to such a method on their own and in independent manner. The wording of the claims is made a part of the description by express reference.

A circuit arrangement according to the invention comprises a circuit carrier with contact pads and conductor tracks thereon. This may be a conventional PCB as well as any other suitable circuit carrier, wherein electronic components provided on the circuit carrier. These electronic components may generate heat in their operation, which heat is to be dissipated and the electronic components are to be cooled, respectively. This serves to avoid any damage to the electronic components, to the circuit carrier itself as well as to any other components provided on or in vicinity to the circuit carrier. For dissipating the heat from the electronic components or for their cooling, respectively, at least one heat sink is provided. This heat sink shall receive heat or take heat from the circuit carrier and/or from the electronic components provided on it in known manner, for example for distributing the heat into the surrounding air or into a stream of cooling air from a fan or the like. The heat sink is either made of electrically conductive material, preferably from metal such as aluminum. Alternatively, the heat sink is at least partly electrically conductive on its outside, which may be achieved by attaching separate metal strips or the like to it. The heat sink is also fastened to the circuit carrier and bears directly against the circuit carrier, at least with projection regions, projections or the like. This serves to hold the heat sink in place and in a defined position relative to the circuit carrier and to the electronic components thereon.

The circuit arrangement in the invention has at least two electrical contacts, which are separate from another or have a distance of at least several millimeters or centimeters from each other. These electric contacts are provided or arranged on the side of the circuit carrier against which the heat sink bears directly. Against these electrical contacts the heat sinks rests and bears in an electrically conductive manner with its electrically conductive material as has been explained before. This has to be such that the heat sink provides an electrically conductive connection between these at least two electrical contacts. These electrical contacts are again electrically connected to conductor tracks or form a part thereof, where the conductor tracks lead to a control of or for the circuit arrangement, which control may eventually be provided on the circuit carrier itself, for example as a microcontroller. This serves to determine an electric through-contacting by means of the heat sink as electrically connecting element, which electric through-contacting includes the two electrical contacts. In plain words, the electrically conductive material of the heat sink connects to both electrical contacts, either due to its own conductivity or due to the conductivity of the separate metal strips attached to it. This conductivity can easily be determined or measured to detect whether the heat sink connects, at least partly, to the electrical contacts and consequently bears directly against the circuit carrier as is defined for a good result of a mechanical connection of the heat sink to a circuit carrier as well as a good thermal connection for a defined cooling effect. In case the at least two electrical contacts are not connected to each other, which is only possible via the heat sink, the heat sink is not in its proper position and thus cannot have the necessary cooling effect. In this manner, other methods of measuring or determining a position of the heat sink on the circuit carrier including mechanical measurement, optical measurement or the like are not necessary. These are regularly much more complicated and cost-intensive.

If the heat sink is made of aluminum, in particular also on its outside and in the regions where it bears directly against the circuit carrier and against the at least two electrical contacts mentioned before, this is sufficient for the purpose of the invention. Although aluminum is not a very good electrical conductor on its outer surface, which outer surface can be coated with aluminum oxide, this electrical conductivity is still sufficient for the purpose of detecting a direct electrical contact between the at least two electrical contacts. If the heat sink is either not made of electrically conductive material or at least not on its outside, electrically conductive material may be attached or applied specifically for this purpose. This may be in the form of a thin strip of aluminum, brass or copper for example, which may be adhesively fixed to the heat sink connecting the two regions where the heat sink directly abuts the electrical contacts. Other electrically conductive material for a heat sink, apart from metal such as iron, brass, copper or the like, could be ceramic material with good thermal and/or electrical conductivity, such as for example aluminum nitride or silicon carbide.

In an embodiment of the invention the two electrical contacts are provided on opposite regions of the heat sink or in two regions of the heat sink which are at a maximum distance from one another and which are to resting against the circuit carrier. These regions are the parts with which the heat sink bears directly against the circuit carrier, and the electrical contacts provided on the surface of the circuit carrier. The measuring of an electrical contact in opposite regions of the heat sink has the advantage that in most cases the heat sink will bear against the circuit carrier in the desired manner not only in these two regions, but also in all the regions where it shall bear against the circuit carrier. This embodiment may be of very simple and cost-efficient design.

In a further embodiment of the invention, four electrical contacts are provided on the circuit carrier for abutment of the heat sink thereon. All these four electrical contacts should be electrically isolated from one another and should also be electrically connected to the control mentioned above for determining an electrical through-contacting via the heat sink. This is especially advantageous in a case where the heat sink is rectangular in a projection from above and has four corner regions, where all four corner regions shall be fixed to the circuit carrier. In consequence, an electrical contact is provided on the circuit carrier for each corner region of the heat sink. In a further advantageous embodiment of the invention, the heat sink is connected to an electrical contact in every region where it bears against the circuit carrier and/or where it is fixed to the circuit carrier. Even though the number of electrical through-contactings increases with this as well as the effort of its testing, this guarantees a good test of whether the heat sink bears against the circuit carrier as it should.

In an advantageous embodiment of the invention, the heat sink has metallic fasteners, which may be an integral part of the heat sink or which may be fastened to it, for example by screwing, riveting or pressing in with sufficient force. These metallic fasteners may in particular consist of material that can be fixed by soldering or by a respective metal. They can be in the form of projections such as pins or pegs. These metallic fasteners serve to securely fasten the heat sink to the circuit carrier, preferably by soldering, alternatively by screwing, riveting, punching in, bending around or a by a latching connection. In particular for an embodiment where the metallic fasteners are to be soldered to the circuit carrier or to metallic contact pads or contact rings on the circuit carrier, the metallic fasteners may be designed as metal pins or pegs affixed to the heat sink as mentioned before. They may for example be screwed into respective threads in the heat sink, alternatively they can be pushed or pressed into corresponding bores in the heat sink. A part of the metal fasteners or pins is affixed in the heat sink, and another part projects from the heat sink and can be projecting through respective holes in the circuit carrier, where they project over an underside of the circuit carrier. Here they may be fastened in any of the methods described above, preferably by soldering to metal contact pads on the underside of the circuit carrier. The advantage of soldering is that this is a way of providing fixing as well as electrical contact on the circuit carrier in any way. These metal pins again should preferably not be electrically connected to the electrical contacts for measurement whether the heat sink bears against the circuit carrier, as they may in any case provide for a contact even if the heat sink does not yet bear against the circuit carrier as defined or is in a defined relative position to it.

In a further embodiment of the invention, the heat sink may be affixed to the circuit carrier with projecting regions which may be in the form of legs. In a region between these projecting regions, the heat sink may be at some distance to the upper side of the circuit carrier, for example between 2 mm and 20 mm. This underside of the heat sink may have a relatively large area compared to the area or the projection of the heat sink itself, for example between 50% and 95%. The space between the heat sink underside and the circuit carrier may preferably be filled with heat-conducting material, which material shall transport or conduct heat away from the circuit carrier or electrical components provided thereon to the heat sink via its underside. This can for example be so-called TI material such as Gap Pad. The heat-conducting material should be placed between the heat sink and the circuit carrier before attaching the heat sink to the circuit carrier, resulting in the heat-conducting material to be in very good contact with the underside of the heat sink as well as with the upper side of the circuit carrier. The heat-conducting property of such heat-conducting material may even be enhanced by exposing it to a certain defined pressure in the assembly state. This pressure or compression may result from compressing the heat-conducting material between 5% and 50%, preferably between 10% and 30%. The pressure may be such that if a TI material is used as heat-conducting material, it has a certain course of its Young modulus as a relation between stress and distance about which it is compressed. At a certain point of compression, the stress rises suddenly and very steep, and this is the point at which the heat-conducting material should be compressed in the final assembly state between the heat sink and the circuit carrier. At this certain point, the heat-conducting properties are at an optimum, where the heat-conducting material is preferably elastic and fits perfectly to the surface contour of the circuit carrier even if there should be conductor tracks or the like, which result in the surface of the circuit carrier not being perfectly plane. With a metal heat sink such a good direct contact would not be possible.

The provision of elastic heat-conducting material on the underside of the heat sink can be used in either case where the electrical components of the circuit carrier, which are to be cooled, are provided on the upper side of the circuit carrier facing the heat sink and, also, on the underside of the circuit carrier facing away from the heat sink. Even in such a case where the electronic component is mounted on the underside of the circuit carrier, while the heat sink is at the opposite side, heat can be transported in quite an efficient way from the heat generating electronic component to the heat dissipating heat sink. For this reason, the heat-conducting material is provided at the underside of the heat sink.

In a preferred embodiment of the invention, the heat-conducting material may be in the form of a foam and also be an elastic material. It can be attached to the heat sink as a separately manageable component or part, for example it can be fixed by adhesive bonding to the underside of the heat sink. Furthermore, in the assembly state of the circuit arrangement, the heat-conducting material can be arranged in compressed form between the heat sink and the circuit carrier or its upper side, respectively. This may not only serve to keep the heat-conducting material in a safe and defined position, but also, as has been explained above with regard to the Young modulus, may even serve to achieve better heat-conducting properties. This is quite logical, as the heat-conducting material becomes more dense when being compressed, which again not only serves to make the length of the path of heat transfer to the heat sink shorter, but also to enhance the heat-conducting property.

In this assembly state, the heat-conducting material may have a thickness of between 0.2 mm to 3 mm, which is rather thin. In particular, such a thickness may be between 0.5 mm and 1.5 mm. A compression of the material may be such that a pressure is between 10 psi and 90 psi, where a thermal impedance may be reduced by about 30% to 60%. A compression ratio for the heat-conducting material may be between 5% and 70%, preferably between 7% and 60%.

The elastic properties of such a heat-conducting material may be such that it can have a hardness of between 25 Shore C up to 50 Shore C. The thermal impedance may be between 1.4 °C x in²/W and 0.4 °C x in²/W.

In a method according to the invention for manufacturing such a circuit arrangement, a circuit carrier with holes, contact pads or contact fields and conductor tracks is provided. Also a heat sink is provided, preferably with elastic heat-conducting material fixed to its underside. In a subsequent step, the heat sink is pressed against the circuit carrier, in particular in a position corresponding to the assembly state. This pressing may be done with a predetermined force, such that the heat sink abuts at least in some areas where the electrical contacts are arranged on the upper side of the circuit carrier. Then the heat sink will abut these electrical contacts. In a further subsequent step, the heat sink is attached to the circuit carrier as described above, preferably by means of soldering in a flow-through process or in a wave soldering process. The heat sink will still bear against the electrical contacts.

In a further subsequent step it is determined by means of an electrical test whether two electrical contacts are electrically connected to one another only by means of the heat sink or via the heat sink, respectively. This can easily be tested by the heat sink being electrically conductive, at least on its outside or due to its material properties. A resistance need not necessarily be down to zero, but should be reduced significantly.

If the test mentioned above has been successful, meaning that there is an electrically conductive connection between the two electrical contacts via the heat sink itself, the circuit arrangement is processed further, for example by attaching further components to the circuit carrier. If the test has been unsuccessful, the circuit arrangement may either be reworked or sorted out. In the first case, it may be tried once more to fix the heat sink to the circuit carrier such that the defined position has been reached. If this is not possible or not feasible, the circuit arrangement that has been produced so far is sorted out.

These and further features may be gathered from the claims and also from the description and the drawings, with the individual features being capable of being implemented in each case by themselves or severally in the form of sub-combinations in an embodiment of the invention and in other fields and being capable of constituting advantageous and independently patentable versions for which protection is claimed here. The subdivision of the application into individual sections and intermediate headings does not restrict the general validity of the statements made under these.

### Short description of the drawings

Embodiments of the invention are shown in the drawings and will be described in detail hereinafter. The drawings show:
- Fig. 1: a side view of a circuit arrangement according to the invention with a PCB having a number of IGBT on the underside and a heat sink on the upper side above them with some distance to the PCB,
- Fig. 2: the circuit arrangement of Fig. 1 with the heat sink being pressed against the PCB into a final assembly state,
- Fig. 3: a view onto the underside of the heat sink, which forms an electrical connection between each of the electrical contacts of the PCB,
- Fig. 4: a diagram of a Young modulus of a specific TI material having good thermal conductivity and a non-linear behavior of the pressure versus a thickness reduction,
- Fig. 5: an alternative embodiment of the heat sink in a configuration similar to Fig. 2, and
- Fig. 6: another alternative embodiment of the invention showing a heat sink not being made of electrically conductive material having conductive metal strips on projecting legs for bearing against the PCB.

### Detailed description of the embodiments

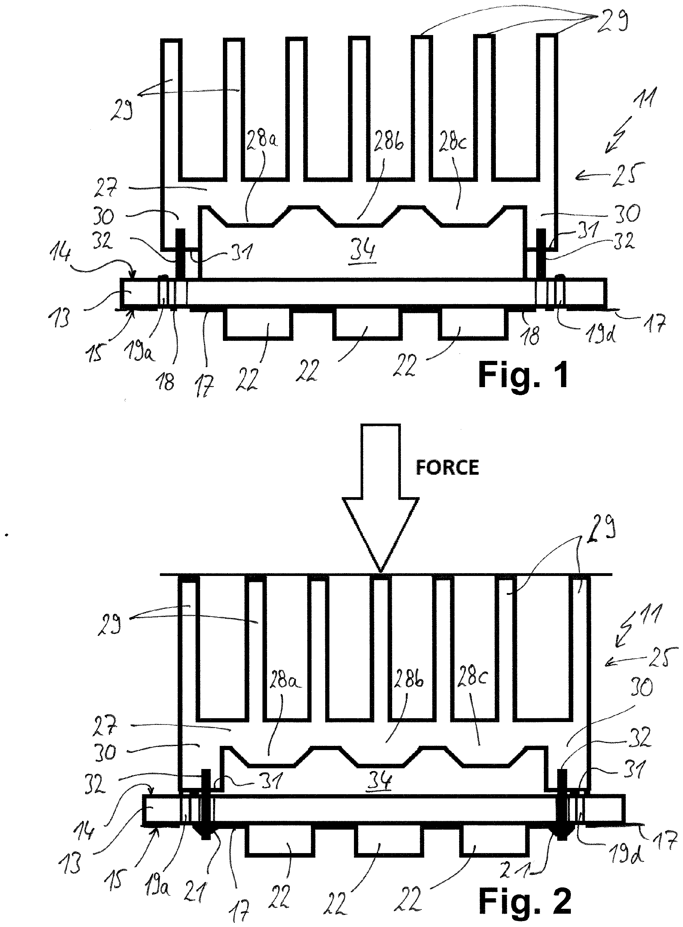

Fig. 1 shows a circuit arrangement 11 according to the invention in a side view. The circuit arrangement 11 has a PCB 13 forming the circuit carrier mentioned before, where the PCB 13 can be a conventional PCB with an upper side 14 and an underside 15. At least on the underside 15, potentially also on the upper side 14, conductor tracks 17 are provided, some of them leading to conductor pads 18. Electrical contacts 19a and 19d are provided in through-holes in the PCB 13. These electrical contacts 19a and 19d can be fabricated by forming the electrically conductive material of the conductor tracks 17 and the conductor pads 18, which can be copper or soldering tin in respective holes through the PCB 13. These electrical contacts 19a and 19d may protrude over the upper side 14 for only a small distance, preferably less than half a millimeter, more preferably down to 0.1 mm. These electrical contacts 19a and 19d are connected to conductor tracks 17, where some of the conductor tracks 17 lead to a schematically shown control 23. Control 23 may be realized in a microcontroller, which can be placed on the PCB 13.

Several IGBT 22 as the above-mentioned heat-generating electronic components are provided on the underside 15 of the PCB 13, for example 6 IGBT 22. They can be designed and mounted to the PCB 13 in SMD technology. They should be in good thermal contact with the underside 15 of the PCB 13, such that their heat can be transferred to and through the PCB 13 to a heat sink 25 provided on the other side, which is on the upper side 14. This is a common technology in the art, which primarily is used where such IGBT 22 or other power electronic components shall not or cannot be in direct contact with a heat sink. Alternatively, this may be due to the IGBT 22 being SMD parts.

The heat sink 25 can be made of aluminum which is a very common material for such heat sinks due to the relatively low weight and relatively high thermal conductivity. The heat sink 25 or its profile, respectively, has a base plate 27 on which several cooling fins 29 are provided, which protrude from the base plate 27 in a direction away from the PCB 13. Also from the underside of the base plate 27 several projecting legs 30 or projecting rails are provided in a direction towards the PCB 13. They have an underside 31 facing the PCB 13, in which underside 31 fastener four pins 32 are affixed. These fastener pins 32 are preferably made of metal which can be soldered, preferably steel, which is plated with nickel or tin, alternatively copper. The fastener pins 32 may simply be fixed or punched into respective bores on the underside 31 of the projecting legs 30. The bores may have a slightly smaller diameter, such that the fastener pins 32, once they have been punched into these bores, are fixed therein and cannot be removed.

As the heat sink 25 is made of aluminum, also the underside 31 of the projecting legs 30 is aluminum and, consequently, electrically conductive on its outside or surface, respectively. As can be taken from the near-assembly state of Fig. 1, the undersides 31 of the projecting legs 30 are facing the upper ends of the electrical contacts 19 with only 1 mm or 2 mm distance. PCB 13 also has respective holes for the fastener pins 32.

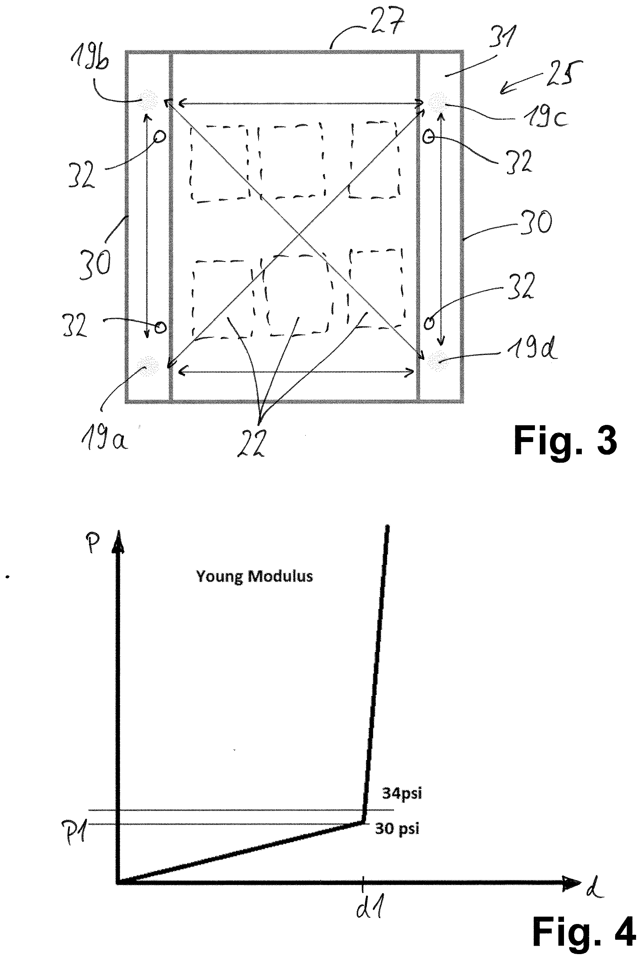

For a better heat transfer from the upper side 14 of the PCB 13 to the heat sink 25, TI material 34 is provided between the two. This TI material preferably is not only electrically isolating, but it may be a foam and also should mainly be an elastic material. It may have a thickness of only a few millimeters, preferably somewhat more than the length of the projecting legs 30 reaching down from the underside of the base plate 27. One such TI material is available under the commercial name of Gap Pad from the company Henkel. The TI material 34 has two specific properties which are of particular use and particular interest in the invention. The first property is that it has a specific Young modulus, which corresponds to an elastic deformation factor. Until a certain deformation, which is shown in Fig. 4, the relation between deformation d and pressure P needed for this deformation is linear. This basically means that the TI material 34 is relatively soft or elastic, respectively. After having reached this point at a certain pressure P1, for example 30 psi, which is a deformation d1 in Fig. 4, the TI material 34 suddenly is much less elastic or may even loose its elastic properties and can thus only be deformed in the manner of a plastic deformation.

Much more pressure is needed for only a slight additional deformation. After deformation of the TI material 34 when being even more compressed than in Fig. 1 into the final assembly state of Fig. 2, when the undersides 31 of the projecting legs 30 bear against the upper side 14 of the PCB 13, the TI material 34 should be shortly before or at the point of deformation d1 of Fig. 4. Then the elastic behavior of the TI material 34 serves for good compressibility for a good and direct contact to the upper side 14 of the PCB 13 on the one hand and also to the underside of the base plate 27 of the heat sink 25 on the other hand.

A further specific property of the TI material 34 is that it has a thermal performance curve that changes with the pressure under which the TI material 34 is. This means that the higher the pressure applied, the better the thermal performance, at least until a certain point. This relationship, however, is not linear having a saturation point. At this saturation point, a higher pressure applied to the TI material 34 does not correspond to a better thermal performance or thermal conductivity, respectively. This results in there being an optimum pressure or compression, respectively, for a given thermal conductivity of the TI material 34. Such leads to the design of the heat sink 25 on the one hand and the thickness of the TI material 34 on the other hand to be designed such that when the heat sink 25 bears completely and directly against the PCB 13, the TI material 34 being compressed between the heat sink 25 and the PCB 13 is at a point shortly before it loses its elastic properties on the one hand and that the thermal conductivity of the TI material 34 is at an optimum or at a desired point.

Fig. 2 shows the final assembly state of the circuit arrangement 11 where the heat sink 25 bears directly against the PCB 13. In detail, the underside 31 of the projecting legs 30 bears fully against the upper side 14 of the PCB 13. The fastener pins 32 are inserted in respective holes in the PCB 13 such that they project over the underside 15. They are affixed to the PCB 13 by solderings 21, preferably on respective conductor pads 18. This does not serve to establish any electrical contact, but just for the mechanical fixing of the heat sink 25.

To verify if the heat sink 25 in fact bears fully and completely against the PCB 13, which is needed for the TI material 34 to have its optimum thermal performance, it can be measured whether the undersides 31 of the projecting legs 30 bear against the electrical contacts 19 which are provided on the upper side 14 of the PCB 13. These electrical contacts 19 are each connected to the control 23 via conductor tracks 17. This allows for the testing of a through-contacting of each of the four electrical contacts 19a to 19d to each of the others, which can be taken from Fig. 3. These through-contactings are shown by thin lines between the electrical contacts 19a to 19d. Fig. 3 shows that the two undersides 31 of the projecting legs 30 fully bear against the electrical contacts 19a to 19d. If an electrical through-connection from every electrical contract 19 to all the three others can be measured, this means that the heat sink 25 bears against these electrical contacts 19 and, consequently, also bears against the upper side 14 of PCB 13. This is a clear sign of the heat sink 25 being in the defined and final assembly state as prescribed. If any of the electrical contacts 19 would not have an electrical through-connection to any or all of the other electrical contacts 19, this would be an indication that the heat sink 25 does not bear against the PCB 13 in the prescribed manner, which would lead to this circuit arrangement 11 either to be a fault part for sorting out or for being repaired manually.

It can also be taken from Fig. 3 by providing the electrical contacts 19a to 19d in the corner regions of the heat sink 25, that this is a guarantee for detecting a prescribed final assembly state. As the heat sink 25 is made of solid and stable aluminum, it is not to be supposed that any part of it might be bent or bulged away from the PCB 13.

Fig. 3 also shows that six IGBT 22, which are shown in dashed lines, are provided between the two projecting legs 30. It can also be taken that there is quite some distance between the electrical contacts 19a to 19d and the fastener pins 32.

Another specific feature from Fig. 1 is the provision of protrusions 28a to 28c on the underside of the base plate 27. These protrusions 28 may protrude for about 0.1 mm to 1 mm. They may serve to put even more pressure on the TI material 34 which is in the direct line between the upper side 14 of the PCB 13 above the IGBT 22 and the protrusions 28. As a result, the length of the path for the heat to be transferred can be shortened for at least a little. Furthermore, the protrusions 28 with their oblique side flanges serve to enlarge the surface of the underside of the base plate 27, which allows for a better heat transfer from the TI material 34 to the heat sink 25 or its underside, respectively. The TI material 34 also contacts the inside of the two projecting legs 30 to also transfer heat therein.

The protrusions 28 can be integrally formed on the heat sink 25 as longitudinal ribs running in the same direction as the line of view of Fig. 1, which also is the same direction as the cooling fins 29 run in. For such an easier manufacturing, the projecting legs 30 should be formed as rails or the like, as can be taken from Fig. 3, instead of providing four single legs which would have to be machined out of the material of the heat sink 25. Then the heat sink may be manufactured as a profile with strand casting of endless length.

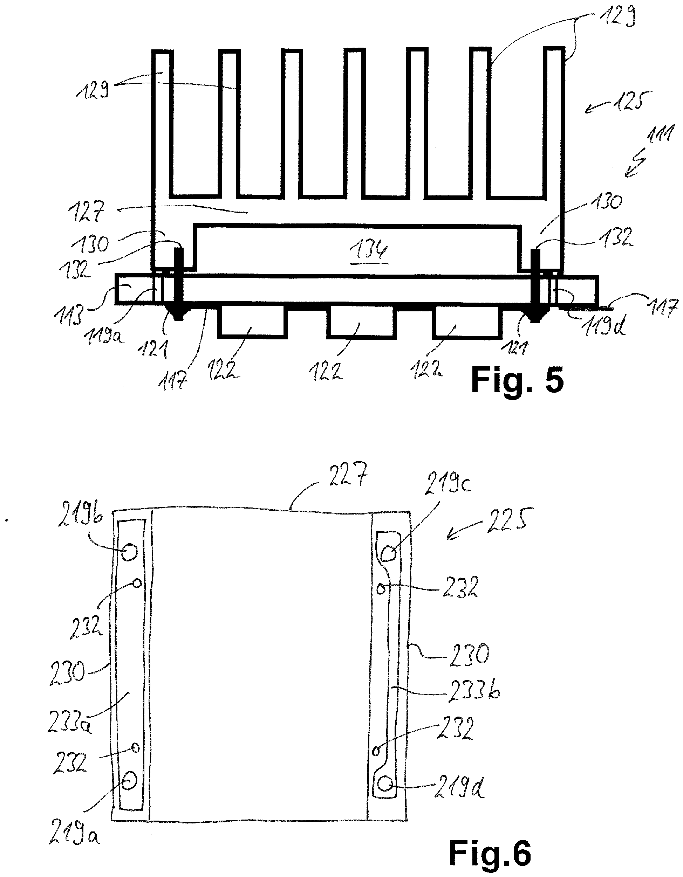

In an alternative and simplified embodiment of the invention according to Fig. 5, a circuit arrangement 111 has the same PCB 13 as described with respect to figs. 1 and 2. The only difference is that a base plate 127 of a heat sink 125 has a flat underside without any protrusions as in Figs. 1 and 2. This reduces the effort for manufacturing the heat sink 125.

Another alternative embodiment is shown in Fig. 6 with a view onto the underside of the heat sink 225, which basically somehow corresponds to Fig. 3. The heat sink 225 also has two projecting legs 230 in the form of longitudinal rails with a depression between them for arranging the TI material as described before. The heat sink 225 is not made of aluminum, and not made of electrically conductive material at all. It could for example be made of ceramic material with a good thermal conductivity, which is essential for a heat sink. This material, however, is electrically insulating such that a direct measurement of a through-contacting as has been described with regard to Fig. 3 is not possible. To avoid this, the left projecting leg 230 is provided with a longitudinal metal strip 233a, which has a constant width. This metal strip 233a could be rather thin with a thickness of 1 mm or less. It could even be in the form of a metal foil and could be fixed to the underside 231 of the left projecting leg 230, for example by adhesive. This metal strip 233a thus corresponds to the electrically conductive surface of a heat sink made of aluminum described above. The metal strip 233a may also contact or be provided close to the fastener pins 232, which is of no regard here. As the metal strip 233a represents the surface of the underside 231 of the projecting leg 230, it can be pressed against the electrical contacts provided in the PCB as described before. This again allows for a testing of a through-contacting to determine whether the heat sink 225 is in the defined final assembly state on a PCB.

An alternative shape of a metal strip 233b is shown on the right projecting leg 230. This metal strip 233b may be of the same material with the same thickness, but obviously with smaller width. This serves to save material and also to provide a certain distance to the fastener pins 232.

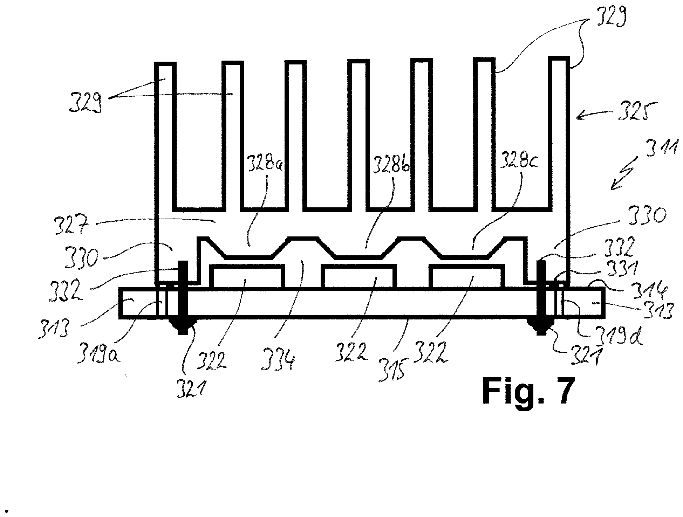

Another alternative embodiment is shown in Fig. 7, which is based on Fig. 2. It also shows the final assembly state of the circuit arrangement 311 where the heat sink 325 bears against the PCB 313 with its projecting legs 330. In detail, the undersides 331 of the projecting legs 330 bear fully against the upper side 314 of the PCB 313 or on the electrical contacts 319a and 319d, respectively. The fastener pins 332 are inserted in respective holes in the PCB 313 such that they project over the underside 315 of the PCB 313 to be firmly affixed by solderings 321, preferably on respective conductor pads. This does not serve to establish any electrical contact, but just for the mechanical fixing of the heat sink 325.

For the electrical contact, the electrical contacts 319a and 319d are provided in the PCB, together with two more such electrical contacts. As in Fig. 2, they abut against the underside 331 of the projecting legs 330 to establish electrical contact. For this, they project somewhat over the upper side 314 of the PCB 313, for example 0.5 mm to 2 mm.

The difference to Fig. 2 is in the arrangement of the IGBT 322 on the upper side 314 of the PCB 313 instead of the underside. The IGBT 322 are arranged rather directly underneath the protrusions 328a to 328c on the underside of the base plate 327 of the heat sink 325 made from aluminum. This results in the TI material 334 to be compressed very much, but still this compression should be in the range of an optimum pressure or compression, respectively, for a given thermal conductivity of the TI material 334. If possible, the TI material 334 should again have its optimum thermal performance. One big advantage of the arrangement of Fig. 7 is that the IGBT 322 are much closer to the heat sink 325 for a shorter distance and, thus, for better cooling.

## Claims

1. Circuit arrangement comprising:
- a circuit carrier with contact pad and conductor tracks thereon,
- electronic components on the circuit carrier, the components generating heat in their operation which is to be dissipated,
- a heat sink for receiving heat from the circuit carrier and/or from the components on the circuit carrier, wherein:
- the heat sink is made of electrically conductive material, in particular aluminum,
- the heat sink is fastened to the circuit carrier and bears directly against the circuit carrier,
**characterized in that**
- at least two electrical contacts, which are separate from one another and against which the heat sink bears in an electrically conductive manner, are arranged on the upper side of the circuit carrier against which the heat sink bears,
- the two electrical contacts are electrically connected to a control in order to determine electrical through-contacting by the heat sink by means of the two electrical contacts.

2. Circuit arrangement according to claim 1, **characterized in that** the two electrical contacts are provided on opposite regions of the heat sink or in two regions of the heat sink which are at a maximum distance from one another and with which the heat sink bears against the circuit carrier.

3. Circuit arrangement according to claim 1 or 2, **characterized in that** four electrical contacts are provided for abutment of the heat sink thereon, all four electrical contacts being electrically isolated from one another and electrically connected to the evaluation, the heat sink preferably being rectangular in projection and having four corner regions, an electrical contact being provided in each corner region.

4. Circuit arrangement according to one of the preceding claims, **characterized in that** the heat sink has metallic fasteners or these metallic fasteners are fastened to it, which metallic fasteners consist in particular of solderable material or metal, by means of which metallic fasteners the heat sink is fastened to the circuit carrier by means of soldering.

5. Circuit arrangement according to claim 4, **characterized in that** the metallic fasteners are designed as metal pins which are fastened to or in the heat sink, in particular by being pressed into corresponding bores, the metal pins preferably projecting through bores into the circuit carrier and being soldered to metallic fastening pads on the opposite side.

6. Circuit arrangement according to one of the preceding claims, **characterized in that** the heat sink has, on an underside facing the circuit carrier, projecting regions, in particular on an outer side, which bears against the circuit carrier as fastening feet, at least one depression being provided between the projecting regions, in particular a single depression, which runs at a distance from the circuit carrier, preferably parallel to the circuit carrier, and over which the projecting regions are protruding.

7. Circuit arrangement according to claim 6, **characterized in that** heat-conducting material is arranged in the depression, which on the one hand rests in the depression and thus on the underside of the heat sink, and on the other hand rests on a component fastened on the upper side of the circuit carrier, which component is to be cooled.

8. Circuit arrangement according to claim 6, **characterized in that** heat-conducting material is arranged in the depression, which on the one hand rests in the depression and thus on the underside of the heat sink, and on the other hand rests on the circuit carrier itself.

9. Circuit arrangement according to claim 8, **characterized in that** at least one electronical component, the heat of which is to be dissipated, is arranged on the underside of the circuit carrier opposite the heat conducting material.

10. Circuit arrangement according to one of the claims 6 to 9, **characterized in that** protrusions are provided on the underside of the base plate, wherein these protrusions protrude for about 0.1 mm to 1 mm from the underside, wherein preferably the protrusions are directly above the electronical components and the heat-conducting material is arranged in between.

11. Circuit arrangement according to one of the claims 7 to 10, **characterized in that** the heat-conducting material is foam and an elastic material and is attached to the heat sink as a separately manageable component, in particular by adhesive bonding, the heat-conducting material preferably being arranged in compressed form between the heat sink and the upper side of the circuit carrier.

12. Circuit arrangement according to one of the claims 7 to 11, **characterized in that** the heat-conducting material is compressed and exposed to a certain defined pressure in the assembly state, wherein the heat-conducting material is compressed between 5% and 50%, preferably between 10% and 30%.

13. Circuit arrangement according to one of the claims 7 to 12, **characterized in that** the heat-conducting material has a thickness of 0.2 mm to 3 mm, in particular a thickness of 0.5 mm to 1.5 mm.

14. Method of manufacturing a circuit arrangement according to one of the preceding claims, **characterized in that**
- in a preceding step, a circuit carrier with holes, contact pads and conductor tracks is provided and a heat sink is provided,
- in a subsequent step, the heat sink is pressed against the circuit carrier, preferably with a predetermined force, so that the heat sink abuts at least in some areas where the electrical contacts are arranged on the upper side of the circuit carrier and thus abuts the electrical contacts,
- in a further subsequent step, the heat sink is attached to the circuit carrier, in particular by means of soldering in a flow-through process or in a wave soldering process,
- in a further subsequent step, it is determined by means of an electrical test whether two electrical contacts are electrically connected to one another by means of the heat sink,
- the circuit arrangement being processed further preferably after an electrically conductive connection has been successfully tested and measured, the circuit arrangement being reworked or sorted out if the test is unsuccessful.
